# EUROPÄISCHE PATENTSCHRIFT

(11) **EP 2 480 903 B1**
(45) Veröffentlichungstag und Bekanntmachung des Hinweises auf die Patenterteilung: **08.04.2015**
(21) Anmeldenummer: 10752795.4
(22) Anmeldetag: 08.09.2010
(51) Int. Cl.: G01R 31/02, H01F 7/18, H03K 17/64, F16K 37/00, H03K 17/082, G05F 1/56, G05F 1/565, F16K 31/06, G01R 1/20

(54) **ELEKTRISCHE SCHALTUNGSANORDNUNG ZUR SCHALTUNG EINES ELEKTRISCHEN VERBRAUCHERS**
ELECTRIC CIRCUIT CONFIGURATION FOR SWITCHING AN ELECTRICAL LOAD
CIRCUIT ÉLECTRIQUE POUR LA COMMUTATION D'UN RÉCEPTEUR ÉLECTRIQUE

(30) Priorität: 24.09.2009 DE 102009044950
(43) Veröffentlichungstag der Anmeldung: 01.08.2012
(73) Patentinhaber: Robert Bosch GmbH, 70442 Stuttgart (DE)
(72) Erfinder: BAUER, Patrick, 70619 Stuttgart (DE); OENCEL, Mehmet, 74357 Boennigheim (DE); CHAUVET, Yannick, 70563 Stuttgart (DE); BAUER, Ralph, 73730 Esslingen (DE); SCHELLING, Bernd, 70469 Stuttgart (DE); HOLST, Thomas, 70499 Stuttgart (DE); HOEGELE, Georg, 70825 Muenchingen (DE)
(86) Internationale Anmeldenummer: PCT/EP2010/063157
(87) Internationale Veröffentlichungsnummer: WO 2011/036056

(56) Entgegenhaltungen:
- EP-A2- 0 415 039
- DE-A1- 3 034 726
- DE-A1- 4 140 586
- DE-A1-102004 028 700
- DE-A1-102006 019 681
- GB-A- 2 032 720
- JP-A- 9 329 270
- JP-A- 2006 100 509
- JP-A- 2008 061 454
- JP-A- 2009 008 207
- US-A1- 2004 155 121
- US-A1- 2004 178 782
- US-A1- 2007 030 068
- US-A1- 2008 204 084

## Beschreibung

Die Erfindung betrifft eine elektrische Schaltungsanordnung zur Schaltung eines elektrischen Verbrauchers, insbesondere eines Magnetventils, mittels eines dem Verbraucher zugeordneten Schaltmittels, insbesondere eines Transistors, wobei die Schaltungsanordnung mindestens eine Auswerteschaltung aufweist. Die Auswerteschaltung umfasst mindestens einen in Reihe mit dem Schaltmittel geschalteten Messwiderstand, mindestens ein erstes Auswertemittel zur Bestimmung einer dem Kurzschlussstrom entsprechenden Größe und mindestens ein zweites Auswertemittel zur Bestimmung einer dem Verbraucherstrom entsprechender Größe.

### Stand der Technik

Elektrische Schaltungsanordnungen zur Schaltung eines elektrischen Verbrauchers mittels eines dem Verbraucher zugeordneten Schaltmittels, insbesondere eines Transistors, und zur Erkennung eines Kurzschlusses sind bekannt. Die Erkennung des Kurzschlusses dient dazu, das Schaltmittels zu öffnen, um im Falle eines Kurzschlusses, beispielsweise des Verbrauchers, Schäden an dem Schaltmittel aufgrund eines zu großen Stroms zu vermeiden. Dazu ist es üblich, einen Spannungsabfall über dem Schaltmittel zu bestimmen und anhand dieses Spannungsabfalls den Kurzschluss zu ermitteln. Besonders bei einer Verwendung eines Transistors als Schaltmittels ist der Widerstand, den der Transistor selbst in geschlossenem Zustand bildet, abhängig von seiner Temperatur. Somit ist keine unmittelbare Beziehung zwischen Spannungsabfall über dem Schaltmittel und einem als Kurzschlussstrom bezeichneten Strom, der im Fall des Kurzschlusses fließt, gegeben. Andererseits ist es ebenfalls üblich, dass der Strom, der durch den elektrischen Verbraucher fließt, mittels einer Auswerteschaltung bestimmt wird. Anhand des so ermittelten Stroms kann ebenfalls der Kurzschuss festgestellt werden. Eine solche Auswerteschaltung ist für die kontinuierliche Bestimmung einer dem durch den Verbraucher fließenden Strom entsprechenden Größe ausgelegt. Die Ermittlung anhand dieser Größe, ob ein Kurzschluss vorliegt, erfolgt in einer der Auswerteschaltung nachgeschalteten Auswerteeinrichtung. Eine solche Schaltungsanordnung mit einer mehrstufigen Auswerteschaltung ist in der Regel für die Feststellung des Kurzschlusses zu langsam und kann daher das Schaltmittel nicht öffnen, bevor dieses aufgrund des Kurzschlusses beschädigt wird.

Eine Schaltungsanordnung, die die Merkmale des Oberbegriffs von Anspruch 1 aufweist, ist aus dem GB 2 032 720 A bekannt. Andere, ähnliche Schaltungsanordnungen sind aus den folgenden Dokumenten bekannt: JP 9 329270 A, DE 41 40 586 A1, DE 10 2004 028700 A1, JP 2008 061454 A, US 2004/155121 A1, DE 10 2006 019681 A1 und US 2004/178782 A1.

### Offenbarung der Erfindung

Demgegenüber weist die elektrische Schaltungsanordnung mit den in Anspruch 1 genannten Merkmalen den Vorteil auf, dass eine dem Kurzschlussstrom entsprechende Größe separat, temperaturunabhängig und ausreichend schnell bestimmt wird. Dazu ist das erste Auswertemittel zu dem Messwiderstand parallel geschaltet. Die erfindungsgemäße elektrische Schaltungsanordnung weist also mindestens ein erstes Auswertemittel, das zur Bestimmung der dem Kurzschlussstrom entsprechenden Größe ausgelegt und optimiert ist, und mindestens ein zweites Auswertemittel auf, das von dem ersten Auswertemittel verschieden ist und zur Bestimmung der dem Verbraucherstrom entsprechenden Größe ausgelegt und optimiert ist. Unter Kurzschlussstrom wird derjenige Strom verstanden, der bei einer bestimmten angelegten Spannung in einem Kurzschlussfall durch das Schaltmittel fließt. Unter dem Verbraucherstrom wird ein Strom verstanden, der bei dem regulären Betrieb, also nicht im Kurzschlussfall, durch den elektrischen Verbrauchers fließt. Dadurch, dass zwei Auswertemittel vorgesehen sind, die getrennt voneinander Kurschluss- und Verbraucherstrom bestimmen, und dadurch, dass das erste Auswertemittel zu dem Messwiderstand parallel geschaltet ist, erfolgt eine unabhängige und schnelle Bestimmung und Auswertung beider Größen. Dabei müssen keine Rahmenbedingungen, wie beispielsweise die Temperatur eines Bauteils, berücksichtigt werden. Der Verbraucher ist beispielsweise ein Magnetventil, also ein induktiver Verbraucher.

Eine Weiterbildung sieht vor, dass das zweite Auswertemittel, das der Bestimmung der dem Verbraucherstrom entsprechenden Größe dient, zu dem Messwiderstand parallel geschaltet ist. Durch das Parallelschalten des zweiten Auswertemittels zu dem Messwiderstand können Kurzschlussstrom und Verbraucherstrom unabhängig voneinander bestimmt werden, wobei lediglich ein einziger Messwiderstand genutzt wird. Dieser Messwiderstand kann auch aus mehreren, miteinander kombinierten beziehungsweise verschalteten Widerständen bestehen. Dadurch, dass zwei unabhängige Auswertemittel zur Bestimmung der dem Kurzschlussstrom entsprechenden Größe und der dem Verbraucherstrom entsprechenden Größe eingesetzt werden, können diese Auswertemittel auf die jeweiligen Strombereiche ausgelegt und optimiert sein, damit eine genaue Auswertung beider Größen erfolgen kann.

Die Erfindung sieht vor, dass die Auswerteschaltung einen weiteren Messwiderstand aufweist, zu dem das zweite Auswertemittel parallel geschaltet ist. Bei dieser Schaltungsanordnung bilden der Messwiderstand mit dem ersten Auswertemittel und der weitere Messwiderstand mit dem zweiten Auswertemittel die Auswerteschaltung. Dabei können der Messwiderstand und das erste Auswertemittel so aufeinander abgestimmt sein, dass die dem Kurzschlussstrom entsprechende Größe beziehungsweise der Kurzschluss bestimmt werden kann. Der weitere Messwiderstand und das zweite Auswertemittel können so aufeinander abgestimmt sein, dass die dem Verbraucherstrom entsprechende Größe bestimmt werden kann. Durch Parallelschaltung jeweils eines Auswertemittels zu einem Messwiderstand kann die Bestimmung der dem jeweiligen Strom entsprechenden Größen über den Spannungsabfall an dem jeweiligen Messwiderstand erfolgen.

Die Erfindung sieht vor, dass der Widerstand des Messwiderstands kleiner ist als der Widerstand des weiteren Messwiderstands. Der Messwiderstand, der der Bestimmung der dem Kurzschlussstrom entsprechenden Größe dient, kann deutlich kleiner sein als der Widerstand des weiteren Messwiderstands, der der Bestimmung der dem Verbraucherstrom entsprechenden Größe dient. Der Messwiderstand ist daher vorzugsweise niederohmig im Verhältnis zu dem weiteren Messwiderstand. Im Fall eines Kurzschlusses fließt ein deutlich größerer Strom als in dem regulären Betrieb des Verbrauchers. Daher kann eine dem Kurzschlussstrom entsprechende Größe bereits mit einem deutlich kleineren Widerstand hinreichend genau bestimmt werden. Darüber hinaus kann so der Spannungsabfall über dem Messwiderstand minimiert werden, wodurch die Schaltung weniger Energie benötigt.

Eine Weiterbildung der Erfindung sieht vor, dass das erste Auswertemittel einen Komparator aufweist. Das erste Auswertemittel, das der Bestimmung der dem Kurzschlussstrom entsprechenden Größe dient, soll in erster Linie schnell den Kurzschluss erkennen können. Ein Komparator ist dazu ein besonders geeignetes Auswertemittel, da der Komparator direkt ein Ergebnis eines Größenvergleichs, beispielsweise von Spannungen, zur Verfügung stellt. Es ist daher möglich, die dem Kurzschlussstrom entsprechende Größe direkt mit einer vorgegebenen Größe zu vergleichen. Das Ergebnis dieses Vergleichs gibt darüber Auskunft, ob ein Kurzschluss vorliegt oder nicht. So kann anhand des Ergebnisses des Komparators ohne Nutzung weiterer Auswertemittel direkt der Kurzschluss ermittelt werden. Über einen Ausgang des Komparators kann in diesem Fall direkt auf eine Ansteuereinrichtung des Schaltmittels eingewirkt werden.

Eine Weiterbildung der Erfindung sieht vor, dass das zweite Auswertemittel einen Operationsverstärker, insbesondere einen Differenzverstärker, aufweist. Das zweite Auswertemittel, das der Bestimmung der dem Verbraucherstrom entsprechenden Größe dient, soll im Gegensatz zu dem ersten Auswertemittel keinen bestimmten Zustand, nämlich den Kurzschluss, feststellen, sondern - vorzugsweise kontinuierlich - eine dem Verbraucherstrom entsprechende Größe ermitteln. Dazu ist insbesondere ein Differenzverstärker besonders geeignet, weil dieser anhand der über dem dem Auswertemittel parallel geschalteten Widerstand abfallenden Spannung dazu geeignet ist, eine dem Verbraucherstrom entsprechende Größe zu bestimmen.

Die Erfindung sieht vor, dass der Messwiderstand und der weitere Messwiderstand in Reihe geschaltet sind. Dies kann mittels einer Verbindungsleitung vorgesehen sein. Durch eine solche direkte Reihenschaltung beider Messwiderstände kann beispielsweise eine gemeinsame Wärmeableitung für beide Widerstände realisiert werden.

Eine Weiterbildung der Erfindung sieht vor, dass eine gemeinsame Messleitung zwischen dem Messwiderstand und dem weiteren Messwiderstand abzweigt und sowohl mit dem ersten als auch mit dem zweiten Auswertemittel verbunden ist. Der Abzweig ist demnach in der Verbindungsleitung vorgesehen. Durch eine gemeinsame Messleitung, die mit dem ersten und zweiten Auswertemittel verbunden ist, können beide Auswertemittel an beide Messwiderstände mit lediglich drei Messleitungen angeschlossen werden. Sind die beiden Auswertemittel beispielsweise gemeinsam auf einer separaten Platine angeordnet, so ergibt sich eine Vereinfachung der Verbindung zwischen dieser Platine und den Messwiderständen, es werden nämlich drei statt vier Messleitungen benötigt.

Eine Weiterbildung der Erfindung sieht vor, dass der Messwiderstand schaltungstechnisch mit einer Masse verbunden ist. Dadurch, dass der Messwiderstand, welcher der Bestimmung der dem Kurzschlussstrom entsprechenden Größe dient, mit Masse verbunden ist, ist beispielsweise eine auf Masse bezogene Auswertung der über dem Kurzschlusswiderstand abfallenden Spannung möglich. Eine solche Auswertung ist, insbesondere in Kombination mit einem Komparator, einfach realisierbar.

Eine Weiterbildung der Erfindung sieht vor, dass die Eingangsmessbereiche des ersten beziehungsweise zweiten Auswertemittels an die dem Kurzschlussstrom beziehungsweise an die dem Verbraucherstrom entsprechende Größe angepasst sind. Durch die Anpassung der Eingangsmessbereiche ist es möglich, sowohl die dem Kurzschlussstrom als auch die dem Verbraucherstrom entsprechende Größe sehr genau zu messen. Dies ist besonders vorteilhaft, wenn der Messwiderstand ohne eine Anpassung der Eingangsmessbereiche der Auswertemittel nicht oder nur bedingt dazu geeignet ist, sowohl die dem Kurzschlussstrom als auch die dem Verbraucherstrom entsprechende Größe zu ermitteln.

Die Erfindung wird nachfolgend anhand der in den Zeichnungen dargestellten Ausführungsformen erläutert, ohne dass diese eine Beschränkung der Erfindung darstellen. Es zeigen:
- Figur 1: ein erstes Ausführungsbeispiel der erfindungsgemäßen Schaltung und
- Figur 2: ein weiteres Ausführungsbeispiel der erfindungsgemäßen Schaltung.

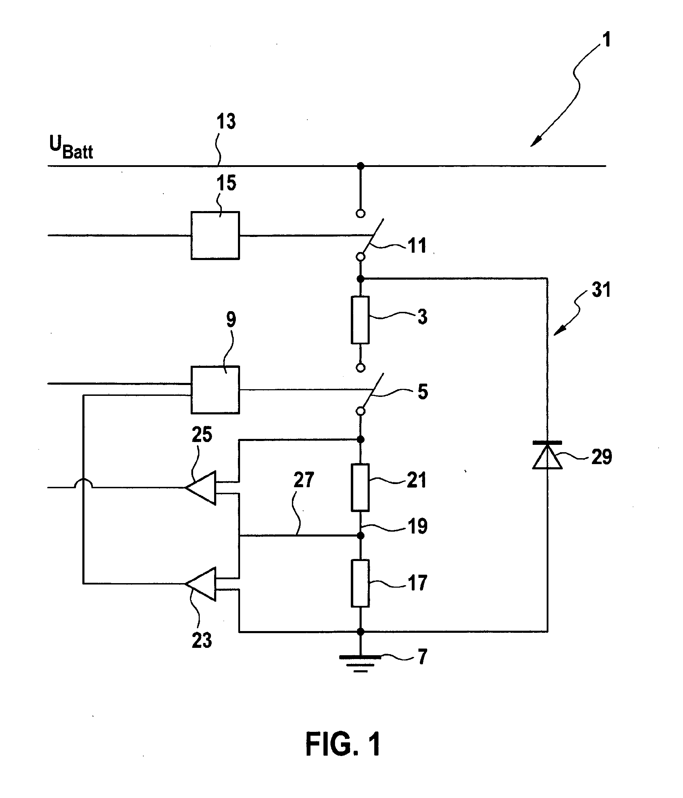

Figur 1 zeigt eine erste Schaltungsanordnung 1 mit einem elektrischen Verbraucher 3, der schaltungstechnisch einerseits mit einem ersten Schaltmittel 5 verbunden ist. Auf das erste Schaltmittel 5 wirkt eine erste Ansteuereinrichtung 9 derart ein, dass das Schaltmittel 5 geöffnet und geschlossen werden kann. Der Verbraucher 3 steht andererseits über ein zweites Schaltmittel 11 schaltungstechnisch mit einer Spannungsversorgungseinrichtung 13 in Verbindung. Die Spannungsversorgungseinrichtung 13 stellt eine Spannung U_{Batt} zur Verfügung. Eine zweite Ansteuereinrichtung 15 wirkt auf das zweite Schaltmittel 11 ein, so dass dieses geöffnet und geschlossen werden kann. Der elektrische Verbraucher 3 ist eingeschaltet, wenn beide Schaltmittel 5 und 11 geschlossen sind. Sobald eines der Schaltmittel 5 und 11 geöffnet ist, ist der Verbraucher 3 ausgeschaltet.

Ein Messwiderstand 17 ist einerseits schaltungstechnisch mit einer Masse 7 und andererseits über eine Verbindungsleitung 19 mit einem weiteren Messwiderstand 21 verbunden. Der weitere Messwiderstand 21 ist über das Schaltmittel 5 mit dem Verbraucher 3 verbunden. Dem Messwiderstand 17 ist ein erstes Auswertemittel 23 parallel geschaltet, das der Bestimmung einer dem Kurzschlussstrom entsprechenden Größe dient. Dem weiteren Messwiderstand 21 ist ein zweites Auswertemittel 25 parallel geschaltet, das der Bestimmung einer dem Verbraucherstrom entsprechenden Größe dient. Dabei entspricht der Kurzschlussstrom einem Strom, der bei einem Kurzschluss, beispielsweise des Verbrauchers 3, durch die Schaltmittel 5 und 11 fließt. Der Verbraucherstrom entspricht dem Strom, der in einem regulären Betrieb des Verbrauchers 3 durch diesen fließt. Die Auswertemittel 23 und 25 sind mit einer gemeinsamen Messleitung 27 an die Verbindungsleitung 19 der Messwiderstände 17 und 21 angeschlossen. Das erste Auswertemittel 23 ist beispielhaft mit der ersten Ansteuereinrichtung 9 des Schaltmittels 5 schaltungstechnisch verbunden, so dass die erste Ansteuereinrichtung 9 das Schaltmittel 5 anhand eines Signals des ersten Auswertemittels 23, welches beispielsweise bei Feststellen eines Kurzschlusses mittels des Auswertemittels 23 ausgegeben wird, öffnen kann. So ist ein direkter und schneller Kurzschlussschutz realisiert, der unabhängig von weiteren Parametern, wie beispielsweise einer Temperatur eines Bauteils, das Schaltmittel 5 im Kurzschlussfall öffnet. Dadurch ist gleichzeitig das Schaltmittel 11 geschützt, weil bei geöffnetem Schaltmittel 5 kein Strom durch das Schaltmittel 11 fließen kann. Das zweite Auswertemittel 25 kann beispielsweise mit einer hier nicht dargestellten Steuer- und/oder Regelungseinrichtung verbunden sein, die wiederum auf die Ansteuereinrichtungen 9 und 15 der Schaltmittel 5 und 11 oder unmittelbar auf letztere einwirken kann, wodurch im regulären Betrieb das Öffnen und Schließen der Schaltmittel 5 und/oder 11 gesteuert und/oder geregelt werden kann. Dazu steht der Steuer- und/oder Regelungseinrichtung ein Signal des zweiten Auswertemittels 25 zur Verfügung, das beispielsweise dem Verlauf einer dem Verbraucherstrom entsprechenden Größe entspricht. Es kann somit beispielsweise eine Stromregelung durch Takten der Spannung erfolgen. Darüber hinaus ist es möglich, anhand der dem Verbraucherstrom entsprechenden Größe Informationen über den Verbraucher 3 abzuleiten. In dem Fall, dass die Bestimmung der dem Verbraucherstrom entsprechenden Größe ergibt, dass kein Strom durch den Verbraucher 3 fließt, kann beispielsweise davon ausgegangen werden, dass der Verbraucher 3 einen Defekt aufweist. Darüber hinaus kann durch Auswerten des Verlaufs der dem Verbraucherstrom entsprechenden Größe beispielsweise das Öffnen beziehungsweise der Öffnungszeitpunkt eines als Magnetventil ausgebildeten Verbrauchers 3 festgestellt werden. Die erste Schaltungsanordnung 1 weist zusätzlich eine Diode 29 auf. Durch die parallele Anordnung der Diode 29 zu dem Verbraucher 3 und den Messwiderständen 17 und 21 wird ein Freilaufkreis 31 realisiert, der beispielsweise den elektrischen Verbraucher 3 vor Beschädigungen schützt, wenn dieser induktive Eigenschaften aufweist.

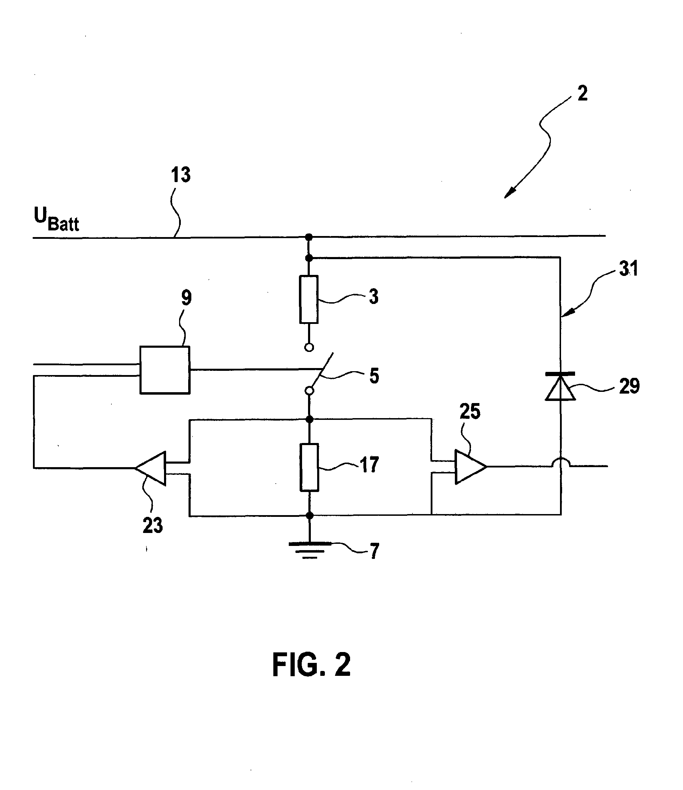

Figur 2 zeigt eine zweite Schaltungsanordnung 2 der erfindungsgemäßen Schaltungsanordnung 1. Elemente, die den Elementen der Figur 1 entsprechen, sind mit gleichen Bezugsziffern versehen. Figur 2 weist ebenfalls den elektrischen Verbraucher 3 auf, der schaltungstechnisch zwischen der Spannungsversorgungseinrichtung 13 und dem ersten Schaltmittel 5 angeordnet ist. Die erste Ansteuereinrichtung 9 wirkt auf das Schaltmittel 5 ein, so dass das Schaltmittel 5 geöffnet und geschlossen werden kann. Ferner ist der Messwiderstand 17 in Reihe mit dem Verbraucher 3 geschaltet. Der Messwiderstand 17 ist darüber hinaus mit der Masse 7 verbunden. Das erste Auswertemittel 23 ist zu dem Messwiderstand 17 parallel geschaltet. Das zweite Auswertemittel 25 ist von dem ersten Auswertemittel 23 verschieden, aber ebenfalls parallel zu dem Messwiderstand 17 geschaltet. Das erste Auswertemittel 23, das der Bestimmung einer dem Kurzschlussstrom entsprechenden Größe dient, wirkt derart auf die erste Ansteuereinrichtung 9 ein, dass diese in einem Kursschlussfall, insbesondere wenn der Verbraucher 3 einen Kurzschluss aufweist, das Schaltmittel 5 öffnet, so dass dieses durch den im Kurzschlussfall fließenden Strom nicht beschädigt wird. Darüber hinaus kann auf die erste Ansteuereinrichtung 9 eine hier nicht dargestellte Steuer- und/oder Regelungseinrichtung einwirken, die im regulären Betrieb der Schaltungsanordnung 2 über die erste Ansteuereinrichtung 9 das Schaltmittel 5 öffnet oder schließt. Das zweite Auswertemittel 25, das der Bestimmung einer dem Verbraucherstrom entsprechenden Größe dient, kann ebenfalls mit der Steuer- und/oder Regelungseinrichtung verbunden sein. Diese Steuer- und/oder Regelungseinrichtung erhält so ein Signal, dass dem Verlauf der dem Verbraucherstrom entsprechenden Größe entspricht. Über dieses Signal kann der reguläre Betrieb des Verbrauchers 3 gegebenenfalls anhand des Schaltmittels 5 gesteuert und/oder geregelt werden. Durch die Trennung der Bestimmung der dem Kurzschlussstrom und der dem Verbraucherstrom entsprechenden Größen können Verbraucher- und Kurzschlussstrom unabhängig voneinander ermittelt werden. Dazu kann es vorgesehen sein, dass die Eingangsmessbereiche des ersten Auswertemittels 23 und des zweiten Auswertemittels 25 jeweils an die dem Kurzschlussstrom beziehungsweise an die dem Verbraucherstrom entsprechende Größe angepasst sind, insbesondere wenn der Messwiderstand 17 keine ausreichend genaue oder ausreichend schnelle Bestimmung beider Größen zulässt.

## Patentansprüche

1. Elektrische Schaltungsanordnung zur Schaltung eines elektrischen Verbrauchers (3), insbesondere eines Magnetventils, mittels mindestens eines dem Verbraucher (3) zugeordneten Schaltmittels (5), insbesondere eines Transistors, wobei die Schaltungsanordnung mindestens eine Auswerteschaltung aufweist mit mindestens einem in Reihe zu dem Schaltmittel (5) geschalteten Messwiderstand (17), mindestens einem ersten Auswertemittel (23) zur Bestimmung einer dem Kurzschlussstrom entsprechenden Größe und mindestens einem zweiten Auswertemittel (25) zur Bestimmung einer dem Verbraucherstrom entsprechenden Größe, wobei das erste Auswertemittel (23) zu dem Messwiderstand (17) parallel geschaltet ist, **dadurch gekennzeichnet, dass** die Auswerteschaltung einen weiteren Messwiderstand (21) aufweist, zu dem das zweite Auswertemittel (25) parallel geschaltet ist, wobei der Widerstand des Messwiderstands (17) kleiner ist als der Widerstand des weiteren Messwiderstands (21), und wobei der Messwiderstand und der weitere Messwiderstand (17,21) in Reihe geschaltet sind.

2. Elektrische Schaltungsanordnung nach einem der vorhergehenden Ansprüche, **dadurch gekennzeichnet,** dass das erste Auswertemittel (23) einen Komparator aufweist.

3. Elektrische Schaltungsanordnung nach einem der vorhergehenden Ansprüche, **dadurch gekennzeichnet,** dass das zweite Auswertemittel (25) einen Operationsverstärker, insbesondere einen Differenzverstärker, aufweist.

4. Elektrische Schaltungsanordnung nach Anspruch 1, **dadurch gekennzeichnet,** dass eine gemeinsame Messleitung (27) zwischen dem Messwiderstand und dem weiteren Messwiderstand (17,21) abzweigt und sowohl mit dem ersten als auch mit dem zweiten Auswertemittel (23,25) verbunden ist.

5. Elektrische Schaltungsanordnung nach einem der vorhergehenden Ansprüche, **dadurch gekennzeichnet,** dass der Messwiderstand (17) schaltungstechnisch mit einer Masse (7) verbunden ist.

6. Elektrische Schaltungsanordnung nach einem der vorhergehenden Ansprüche, **dadurch gekennzeichnet,** dass die Eingangsmessbereiche des ersten beziehungsweise des zweiten Auswertemittels (23,25) an eine dem Kurzschlussstrom beziehungsweise an eine dem Verbraucherstrom entsprechende Größe angepasst sind.

## Claims

1. Electric circuit configuration for switching an electrical load (3), in particular a solenoid valve, by means of at least one switching means (5) associated with the load (3), in particular a transistor, wherein the circuit configuration has at least one analysis circuit having at least one measuring resistor (17) connected in series with the switching means (5), at least one first analysis means (23) for determining a parameter corresponding to the short-circuit current, and at least one second analysis means (25) for determining a parameter corresponding to the load current, wherein the first analysis means (23) is connected in parallel with the measuring resistor (17), **characterized in that** the analysis circuit has a further measuring resistor (21), with which the second analysis means (25) is connected in parallel, wherein the resistance of the measuring resistor (17) is less than the resistance of the further measuring resistor (21), and wherein the measuring resistor and the further measuring resistor (17, 21) are connected in series.

2. Electric circuit configuration according to one of the preceding claims, **characterized in that** the first analysis means (23) has a comparator.

3. Electric circuit configuration according to one of the preceding claims, **characterized in that** the second analysis means (25) has a an operational amplifier, in particular a differential amplifier.

4. Electric circuit configuration according to Claim 1, **characterized in that** a common measuring lead (27) branches off between the measuring resistor and the further measuring resistor (17, 21) and is connected to both the first and to the second analysis means (23, 25).

5. Electric circuit configuration according to one of the preceding claims, **characterized in that** the measuring resistor (17) is connected by circuitry to a ground connection (7).

6. Electric circuit configuration according to one of the preceding claims, **characterized in that** the input measuring ranges of the first and second analysis means (23, 25) respectively are matched to a parameter corresponding to the short-circuit current and to the load current respectively.

## Revendications

1. Circuit électrique destiné à raccorder un consommateur électrique (3), en particulier une soupape magnétique, au moyen d'au moins un moyen de commutation (5) associé au consommateur (3), en particulier un transistor, le circuit présentant
au moins un circuit d'évaluation doté d'au moins une résistance de mesure (17) raccordée en série avec le moyen de commutation (5),
au moins un premier moyen d'évaluation (23) qui détermine une grandeur qui correspond à un courant de court-circuit et
au moins un deuxième moyen d'évaluation (25) qui détermine une grandeur correspondant au courant du consommateur,
le premier moyen d'évaluation (23) étant raccordé en parallèle sur la résistance de mesure (17), **caractérisé en ce que**
le circuit d'évaluation présente une autre résistance de mesure (21) à laquelle le deuxième moyen d'évaluation (25) est raccordé en parallèle,
**en ce que** la valeur de la résistance de mesure (17) est inférieure à la valeur de l'autre résistance de mesure (21) et
**en ce que** la résistance de mesure ainsi que l'autre résistance de mesure (17, 21) sont raccordées en série.

2. Circuit électrique selon la revendication 1, **caractérisé en ce que** le premier moyen d'évaluation (23) présente un comparateur.

3. Circuit électrique selon l'une des revendications précédentes, **caractérisé en ce que** le deuxième moyen d'évaluation (25) présente un amplificateur opérationnel et en particulier un amplificateur différentiel.

4. Circuit électrique selon la revendication 1, **caractérisé en ce qu'**un conducteur commun de mesure (27) s'étend entre la résistance de mesure et l'autre résistance de mesure (17, 21) et est raccordé à la fois au premier et au deuxième moyen d'évaluation (23, 25).

5. Circuit électrique selon l'une des revendications précédentes, **caractérisé en ce que** la résistance de mesure (17) est raccordée à une masse (7).

6. Circuit électrique selon l'une des revendications précédentes, **caractérisé en ce que** les plages de mesure d'entrée du premier et du deuxième moyen d'évaluation (23, 25) sont adaptées respectivement au courant de court-circuit et au courant du consommateur.
